# EUROPÄISCHE PATENTSCHRIFT

(11) **EP 4 170 398 B1**
(45) Veröffentlichungstag und Bekanntmachung des Hinweises auf die Patenterteilung: **01.10.2025**
(21) Anmeldenummer: 22187130.4
(22) Anmeldetag: 27.07.2022
(51) Int. Cl.: G02B 6/38, G02B 6/42

(54) **PLATINENSTECKER FÜR EINE LEITERPLATTE**
CIRCUIT BOARD CONNECTOR FOR A CIRCUIT BOARD
CAVALIER POUR UNE CARTE DE CIRCUIT IMPRIMÉ

(30) Priorität: 19.10.2021 DE 102021127032
(43) Veröffentlichungstag der Anmeldung: 26.04.2023
(73) Patentinhaber: MD ELEKTRONIK GmbH, 84478 Waldkraiburg (DE)
(72) Erfinder: Pritz, Helmut, 84539 Ampfing (DE); Halbig, Thomas, 92345 Dietfurt (DE)

(56) Entgegenhaltungen:
- WO-A2-02/23235
- DE-A1- 102006 040 076
- DE-A1- 102019 210 235
- US-A1- 2015 341 066
- US-A1- 2020 127 396
- US-A1- 2020 241 214

## Beschreibung

### Technisches Gebiet

Die Erfindung betrifft einen Steckverbinder für eine Leiterplatine, der lösbar an der Leiterplatine befestigbar ist. Der Steckverbinder ist im Besonderen zur Verbindung der Leiterplatine mit einem Lichtwellenleiter geeignet.

### Stand der Technik

Durch die zunehmende Digitalisierung und Miniaturisierung von Produkten und Prozessen und den damit anfallenden immer größer werdenden Datenmengen wächst auch zunehmend der Bedarf an platzsparenden und kosteneffektiven Datenverbindungen, die hohe Datenübertragungsraten ermöglichen. Da Lichtwellenleiter im besonderen Maße dafür geeignet sind sehr hohe Datenraten zu übertragen, wird die Anwendung von Lichtwellenleitern als Übertragungsmittel von Daten zunehmend interessanter. Die Verbindung der Lichtwellenleiter erfolgt meist über Stecksysteme, sodass der Lichtwellenleiter entweder mit einem weiteren Lichtleiter oder einer Halbleiterplatine lösbar verbunden werden kann. Für die Verbindung mit der Halbleiterplatine werden in der Regel Platinenstecker verwendet, die mit der Halbleiterplatine unlösbar, beispielsweise durch Anlöten, verbunden werden. Das unlösbare Verbinden der Halbleiterplatine erlaubt eine einfache Montage sowie eine genaue und belastbare Anordnung des Platinensteckers auf der Halbleiterplatine, sodass die Lichtübertragung durch den Platinenstecker gewährleistet werden kann.

US 2015/341066 A1 offenbart ein schnappmontierbares optoelektronisches Modul. Das Modul umfasst einen Rahmen, eine Abdeckung und eine Modulverriegelung. Der Rahmen umfasst zwei oder mehr Pfostenblöcke, die jeweils eine Modulverriegelungsaufnahme definieren. Die Abdeckung ist so konfiguriert, dass sie eine innere Baugruppe zumindest teilweise umschließt und eine Aussparung für die Modulverriegelung enthält. Die Modulverriegelung umfasst Drehzapfen und einen Verriegelungsabschnitt. Die Drehzapfen werden in den Modulverriegelungsaufnahmen aufgenommen, so dass die Modulverriegelung in einer entriegelten Position und in einer verriegelten Position konfiguriert werden kann. In der entriegelten Position ist der Verriegelungsabschnitt von der Modulverriegelungsaussparung gelöst. In der verriegelten Position ist der Verriegelungsabschnitt mit der Modulverriegelungsaussparung in Eingriff, um die Abdeckung relativ zum Rahmen zu halten.

DE 10 2006 040076 A1 offenbart einen Lichtwellenleiter-Steckverbinder, der mit einer Aufnahmeöffnung für das Ende eines Lichtwellenleiters und einer Rasteinrichtung versehen ist. Durch die Rasteinrichtung ist das Ende des Lichtwellenleiters in der Aufnahme arretierbar und gegen unbeabsichtigtes Lösen während der Vormontage gesichert. Um die Rasteinrichtung lösen zu können, ist vorgesehen, dass die Rasteinrichtung ein von außerhalb des Lichtwellenleiter-Steckverbinders frei zugänglich angeordnetes Betätigungsorgan aufweist, das in eine Betätigungsstellung überführbar ausgestaltet ist. In der Betätigungsstellung ist die Arretierung des Lichtwellenleiters freigegeben.

WO 02/23235 A2 offenbart eine Lichtwellenleiterbuchse und einen Lichtwellenleiterstecker, sowie eine Lichtwellenleiterbuchsen-Anordnung. Die Lichtwellenleiterbuchse hat ein Buchsengehäus, das eine Aufnahmekammer zur Aufnahme eines zugeordneten Lichtwellenleitersteckers aufweist, und eine Verriegelungsvorrichtung zum Verriegeln des in der Aufnahmekammer aufgenommenen Lichtwellenleitersteckers. Die Verriegelungsvorrichtung ist mit einem elektrisch leitenden Abschnitt versehen, der unter Ausbildung eines elektrischen Kontakts mit einem elektrisch leitenden Gegenstück des eingesteckten Lichtwellenleitersteckers in Berührungskontakt ist. Ferner hat die Lichtwellenleiterbuchse ein Anschlussstück, das mit dem elektrisch leitenden Abschnitt der Verriegelungsvorrichtung elektrisch leitend verbunden ist und das seitlich aus dem Buchsengehäuse herausgeführt ist. Gemäß der Lichtwellenleiterbuchsen-Anordnung ist die Lichtwellenleiterbuchse auf einer Leiterplatine angeordnet, die einen elektrisch leitenden Kontaktabschnitt aufweist, der mit dem aus dem Buchsengehäuse hervorstehenden Teil des Anschlussstücks unter Ausbildung eines elektrischen Kontakts in Berührungskontakt steht.

US 2020/241214 offenbart eine faseroptische Steckverbinderbaugruppe, die an einem Ende mit einer Halterung auf einer Leiterplatte verbunden ist und in einen Backplane-Adapter eingesetzt ist, der sich neben einer Backplane befindet. Eine Feder ist gleitend an der Halterung und auch an einem Gehäuse der faseroptischen Steckerbaugruppe befestigt. Das Gehäuse der faseroptischen Steckverbinderbaugruppe kann mit Hilfe passiver Ausrichtungsmerkmale in den Backplane-Adapter eingesetzt werden. Eine faseroptische Ferrule in der faseroptischen Steckverbinderbaugruppe wird durch die Feder in einem Federstößel in eine Vorwärtsrichtung vorgespannt. Gleichzeitig ermöglicht die Feder eine Bewegung des Federstößels innerhalb des Gehäuses, um eine Bewegung der Leiterplatte relativ zum Backplane-Adapter zu ermöglichen.

Aufgrund einer zunehmenden Verknappung von Rohstoffen und eines stetig steigenden Bedarfs an nachhaltigeren Produkten gehen mit der unlösbaren Befestigung des Platinensteckers einige Nachteile einher. Beispielsweise wird durch die unlösbare Verbindung die Wiederverwertbarkeit sowohl der Halbleiterplatine als auch des Platinensteckers deutlich erschwert, da sich die Komponenten nicht vollständig voneinander trennen lassen. Lösbare Befestigungen des Platinensteckers an der Halbleiterplatine haben jedoch den Nachteil, dass sich der Platinenstecker ungewollt von der Halbleiterplatine lösen kann. Weiterhin können Fertigungstoleranzen der Halbleiterplatine oder des Platinensteckers dazu führen, dass der Platinenstecker gegenüber der Halbleiterplatine einen gewissen Bewegungsspielraum aufweist, was die lichtleitende Verbindung, die mit dem Platinenstecker erzeugt werden soll, deutlich verschlechtert.

US 2020/127396 A1 offenbart einen elektrischen Verbinder und ein Verfahren zum Verbinden eines elektrischen Leiters mit einer Platte, insbesondere mit einer Leiterplatte, umfassend ein Gehäuse, das auf einer Verbindungsseite des elektrischen Verbinders mit einem elektrischen Verbindungselement oder Leiter elektrisch verbunden werden kann. Das Gehäuse enthält auf einer Kontaktseite des elektrischen Verbinders einen oder mehrere Kontakte, um einen elektrischen Kontakt mit einem oder mehreren Gegenkontakten der Leiterplatte herzustellen. Eine Verriegelungsstiftanordnung führt durch eine Öffnung der Leiterplatte, wenn der Verbinder auf der Platte montiert ist, und kann sich von einer zurückgezogenen Freigabeposition in eine erweiterte Verriegelungsposition bewegen, in der ihr Durchmesser auf der vom Gehäuse abgewandten Seite der Öffnung größer ist als der Durchmesser der Öffnung der Leiterplatte. Das Gehäuse umfasst mindestens eine Betätigungsvorrichtung, die sich relativ zum Gehäuse bewegt. Die Verriegelungsstiftanordnung umfasst mindestens zwei relativ zueinander bewegliche Funktionselemente.

DE 10 2019 210235 A1 offenbart einen Direktsteckverbinder für die Herstellung einer elektrischen Verbindung zwischen einem Leiter und einer metallisierten Durchgangsöffnung einer Leiterplatte. Der Direktsteckverbinder weist ein Befestigungselement und einen Kontakt mit wenigstens einem ersten Kontaktarm auf. Der erste Kontaktarm ist zur elektrischen Verbindung des Leiters mit der metallisierten Durchgangsöffnung ausgebildet. Das Befestigungselement kann eine Befestigungsposition und eine Freigabeposition einnehmen, wobei das Befestigungselement in der Befestigungsposition zur Befestigung des Direktsteckverbinders an der metallisierten Durchgangsöffnung ausgebildet ist.

### Beschreibung der Erfindung

Es ist daher eine Aufgabe der vorliegenden Erfindung einen Steckverbinder für Leiterplatinen bereitzustellen, der lösbar mit der Leiterplatine verbindbar ist und zumindest einen im Stand der Technik genannten Nachteil überwindet.

Die erfindungsgemäße Aufgabe wird durch einen Steckverbinder gemäß den Merkmalen des unabhängigen Anspruchs erfüllt. Weitere vorteilhafte Ausführungsformen lassen sich den Unteransprüchen, der Beschreibung sowie den Zeichnungen entnehmen.

Ein erfindungsgemäßer Steckverbinder für eine Leiterplatine weist ein Steckverbindergehäuse auf. Das Steckverbindergehäuse weist zumindest ein Befestigungsarm auf. Der erfindungsgemäße Steckverbinder weist weiterhin eine Sicherungseinheit auf. Der Befestigungsarm weist zumindest ein erstes Befestigungselement auf, das mit einem ersten Verbindungselement an der Leiterplatine lösbar verbindbar ist. Das erste Befestigungselement ist vorzugsweise an einem freien Ende des Befestigungsarms angeordnet. Bei dem ersten Befestigungselement kann es sich beispielsweise um einen Rasthaken handeln. Bei dem ersten Verbindungselement kann es sich beispielsweise um eine Rastaufnahme oder eine Rastöffnung handeln. Es ist jedoch ebenso möglich, dass das erste Befestigungselement als Rastöffnung und das erste Verbindungselement als Rasthaken ausgebildet ist. Die Sicherungseinheit ist zwischen einer Freigabeposition und einer Sperrposition bewegbar am Steckverbindergehäuse angeordnet. Die Verbindung zwischen dem ersten Befestigungselement und dem ersten Verbindungselement ist durch ein Auslenken des Befestigungsarms erzeugbar und/oder lösbar. Die Sicherungseinheit blockiert die Auslenkung des Befestigungsarms in der Sperrposition. Die Verbindung zwischen dem ersten Befestigungselement und dem ersten Verbindungselement ist folglich nicht erzeugbar und/oder lösbar, wenn die Sicherungseinheit in der Sperrposition angeordnet ist. Die Sicherungseinheit gibt die Auslenkung des Befestigungsarms in der Freigabestellung frei. Die Verbindung zwischen dem ersten Befestigungselement und dem ersten Verbindungselement ist folglich erzeugbar und/oder lösbar, wenn die Sicherungseinheit in der Freigabestellung angeordnet ist.

Die Sicherungseinheit ist in einer Bewegungsrichtung parallel zu einer Steckachse zwischen der Freigabeposition und der Sperrposition bewegbar. Unter der Steckachse kann in diesem Zusammenhang eine gedachte Richtungsachse verstanden werden entlang derer der Steckverbinder relativ zu einem Gegensteckverbinder bewegt werden muss, um den Steckverbinder mit dem Gegensteckverbinder verbunden werden zu können. Die Bewegungsrichtung, entlang derer die Sicherungseinheit zwischen der Freigabeposition und der Sperrposition bewegbar ist, ist darüber hinaus parallel zu einer größten Seite der Leiterplatine angeordnet.

Das Steckverbindergehäuse weist ein Führungselement auf, das sich parallel zur Steckachse von dem Steckverbindergehäuse wegerstreckt. Das Führungselement kann beispielsweise als Führungsstift ausgeführt sein. Die Sicherungseinheit weist eine Führungsöffnung auf, wobei das Führungselement zumindest teilweise innerhalb der Führungsöffnung angeordnet ist. Das Führungselement ist vorzugsweise sowohl in der Freigabeposition als auch in der Sperrposition innerhalb der Führungsöffnung angeordnet. Mithilfe des Führungselements, das innerhalb der Führungsöffnung angeordnet ist, kann sichergestellt werden, dass die Bewegung der Sicherungseinheit zwischen der Freigabeposition und der Sperrposition geführt erfolgt und somit beispielsweise ein Verkeilen der Sicherungseinheit vermieden werden kann.

Mithilfe des erfindungsgemäßen Steckverbinders ist es auf einfache Weise und mit wenigen Bauteilen möglich eine lösbare, jedoch zuverlässige Verbindung des Steckverbinders mit einer Leiterplatine zu erzeugen. Aufgrund der Sicherungseinheit, die zwischen der Sperrposition und der Freigabeposition bewegbar ist, kann der Steckverbinder jederzeit von der Leiterplatine gelöst werden, sofern eine Demontage des Steckverbinders von der Leiterplatine beabsichtigt ist. Da sowohl die Montage als auch die Demontage des Steckverbinders gegenüber der Leiterplatine zerstörungsfrei und reversibel ist, besteht die zusätzliche Möglichkeit einzelne Komponenten, des Steckverbinders austauschbar zu gestalten, da diese aufgrund der lösbaren Verbindung des Steckverbinders mit der Leiterplatine leichter zugänglich sind. Der erfindungsgemäße Steckverbinder ist zwar im besonderen Maße für eine Verbindung der Leiterplatine mit einem Lichtwellenleiter geeignet, doch kann der Steckverbinder auch bei elektrischen Datenleitungen, wie zum Beispiel Hochfrequenzleitungen, die mit der Leiterplatine verbunden werden sollen, zum Einsatz kommen.

Die Sicherungseinheit kann zumindest ein Fixierungselement aufweisen, das in der Sperrposition mit einem Aufnahmeelement am Befestigungsarm verbunden ist. Das Fixierungselement kann beispielsweise als Fixierungsstift und das Aufnahmeelement kann beispielsweise als Aufnahmeöffnung, insbesondere in Form eines Langlochs, ausgebildet sein. In der Sperrposition ist der Fixierungsstift bevorzugt innerhalb der Aufnahmeöffnung angeordnet. In der Freigabeposition ist der Fixierungsstift bevorzugt außerhalb der Aufnahmeöffnung angeordnet. Der Fixierungsstift und die Aufnahmeöffnung erstrecken sich vorzugsweise senkrecht zu einer Auslenkrichtung, in die der Befestigungsarm auslenkbar ist.

Das Steckverbindergehäuse kann zumindest ein Positionierungselement aufweisen, das in eine Positionierungsöffnung in der Leiterplatine einbringbar ist. Das Positionierungselement kann beispielsweise als Positionierungsstift ausgeführt sein. Die Positionierungsöffnung weist bevorzugt eine komplementäre Form zu einer Außenkontur des Positionierungselements auf, sodass der Steckverbinder möglichst geringen Bewegungsspielraum aufweist, wenn das Positionierungselement in der Positionierungsöffnung angeordnet ist. Es ist von besonderem Vorteil, wenn das Positionierungselement und das Fixierungselement parallel zueinander angeordnet sind.

Das Steckverbindergehäuse kann zumindest ein Anschlagelement aufweisen. Die Leiterplatine kann zwischen dem ersten Befestigungselement und dem Anschlagelement einspannbar sein. Das Anschlagelement kann beispielsweise als Anschlagfläche ausgebildet sein. Durch das Einspannen der Leiterplatine zwischen dem ersten Befestigungselement und dem Anschlagelement, wird der Steckverbinder ortsfest an der Leiterplatine positioniert. Sofern das Steckverbindergehäuse ein Positionierungselement aufweist, ist es von besonderem Vorteil, wenn das Positionierungselement am Anschlagelement angeordnet ist.

Das Steckverbindergehäuse kann ein zweites Befestigungselement aufweisen, das mit einem zweiten Verbindungselement an der Leiterplatine verbindbar ist. Das zweite Befestigungselement ist bevorzugt in einem Einbauzustand auf einer der Leiterplatine zugewandten Grundseite des Steckverbindergehäuses angeordnet. Das zweite Befestigungselement kann in einer Flucht mit dem Positionierungselement angeordnet sein, wobei die Flucht bevorzugt parallel zur Steckachse angeordnet ist. Das zweite Befestigungselement kann derart mit dem zweiten Verbindungselement verbunden sein, dass die Grundseite des Steckverbindergehäuses gegen die Leiterplatine vorgespannt ist. Dies kann beispielsweise realisiert sein, indem das zweite Befestigungselement als federelastischer Rasthaken und das zweite Verbindungselement als Rastöffnung ausgebildet ist.

Das Steckverbindergehäuse kann zwei Befestigungsarme mit jeweils einem ersten Befestigungselement aufweisen. Bevorzugt weist jeder Befestigungsarm jeweils ein erstes Befestigungselement auf, das jeweils mit einem ersten Verbindungselement der Leiterplatine verbindbar ist. Die Befestigungsarme sind zur Erzeugung und/oder Lösung der Verbindung zwischen den ersten Befestigungselementen und den ersten Verbindungselementen vorzugsweise in zueinander entgegengesetzte Richtungen auslenkbar. Die Befestigungsarme sind besonders bevorzugt aufeinander zu oder voneinander weg bewegbar. Die zwei Befestigungsarme sind vorzugsweise in einer Ebene senkrecht zu der Steckachse zueinander angeordnet. Sofern das Steckverbindergehäuse ein zweites Befestigungselement aufweist, bilden die Befestigungsarme bevorzugt ein gleichschenkliges Dreieck mit dem zweiten Verbindungselement aus, wobei die Schenkel des Dreiecks jeweils zwischen einem Befestigungsarm und dem zweiten Befestigungselement ausgebildet werden.

Die Leiterplatine kann zwischen den Befestigungsarmen einspannbar sein. Dies kann beispielsweise realisiert sein, in dem bei einer Verbindung der ersten Befestigungselemente mit den ersten Verbindungselementen die Befestigungsarme gegeneinander vorgespannt sind. Beispielsweise können die ersten Befestigungselemente als Rasthaken und die ersten Verbindungselemente als Rastöffnungen ausgebildet sein. Die ersten Verbindungselemente können einen Abstand zueinander aufweisen, der sich von dem Abstand, den die ersten Befestigungselemente zueinander aufweisen unterscheiden und insbesondere einen größeren Abstand aufweisen. Werden die ersten Befestigungselemente mit den ersten Verbindungselementen verbunden, können beide Befestigungsarme aufgrund des unterschiedlichen Abstandes nicht zurück in ihre Ruhelage bewegt werden, sodass beide Befestigungsarme eine Kraft auf die Leiterplatine auswirken, die die Leiterplatine einspannt. Um die Einspannung der Leiterplatine zwischen den Befestigungsarmen zusätzlich zu verbessern, kann das Anschlagelement zumindest teilweise zwischen den Befestigungsarmen angeordnet sein. Auf diese Weise kann die Vorspannung der Befestigungsarme zusätzlich genutzt werden, um die Leiterplatine zusätzlich zwischen dem Anschlagelement einzuspannen.

Die Befestigungsarme können mithilfe eines Verbindungsabschnitts miteinander verbunden sein. Die Befestigungsarme sind bevorzugt an Enden, die den freien Enden gegenüberliegend angeordnet sind, mit dem Verbindungsabschnitt verbunden. Mithilfe des Verbindungsabschnitts kann insbesondere eine gleichmäßige Vorspannung beider Befestigungsarme auf die Leiterplatine realisiert werden. Weiterhin kann der Verbindungsabschnitt flexibel ausgebildet sein, sodass durch ein Drücken auf den Verbindungsabschnitt die Befestigungsarme auseinander bewegt werden können.

Die Sicherungseinheit kann ein Vorsprungselement aufweisen, das in der Sperrposition eine Druckkraft auf den Verbindungsabschnitt auswirkt, die die Befestigungsarme gegeneinander vorspannt. Das Vorsprungselement erstreckt sich vorzugsweise von der Sicherungseinheit weg und kann beispielsweise als Keil ausgebildet sein. Das Vorsprungselement kann den Verbindungsabschnitt beispielsweise elastisch Verformen, wobei die aus der elastischen Verformung entstehende Spannung die Befestigungsarme gegeneinander vorspannt.

Der Befestigungsarm kann an einer Rückseite des Steckverbindergehäuses angeordnet sein, die gegenüberliegend zu einer Steckseite des Steckverbindergehäuses angeordnet ist.

Auf diese Weise kann nicht nur eine sichere ortsfeste Verbindung des Steckverbinders mit der Leiterplatine sichergestellt werden. Weiterhin ist die Sicherungseinheit leicht zugänglich.

Darüber hinaus sind weitere Vorteile und Merkmale der vorliegenden Erfindung aus der folgenden Beschreibung bevorzugter Ausführungsformen ersichtlich. Die dort und oben beschriebenen Merkmale können alleinstehend oder in Kombination umgesetzt werden, insofern sich die Merkmale nicht widersprechen. Die folgende Beschreibung der bevorzugten Ausführungsformen erfolgt dabei unter Bezugnahme auf die begleitenden Zeichnungen. Dabei zeigen:
- Figur 1: eine dreidimensionale Explosionsansicht einer ersten Ausführungsform eines erfindungsgemäßen Steckverbinders;
- Figur 2: eine dreidimensionale Ansicht der ersten Ausführungsform des erfindungsgemäßen Steckverbinders, wobei eine Sicherungseinheit in einer Freigabeposition angeordnet ist;
- Figur 3: eine dreidimensionale Ansicht der ersten Ausführungsform des erfindungsgemäßen Steckverbinders, wobei die Sicherungseinheit in einer Sperrposition angeordnet ist;
- Figur 4: eine Schnittansicht der ersten Ausführungsform des erfindungsgemäßen Steckverbinders;
- Figur 5a: eine Aufsicht der ersten Ausführungsform des erfindungsgemäßen Steckverbinders, wobei die Sicherungseinheit in der Freigabeposition angeordnet ist; und
- Figur 5b: eine Aufsicht der ersten Ausführungsform des erfindungsgemäßen Steckverbinders, wobei die Sicherungseinheit in der Sperrposition angeordnet ist.

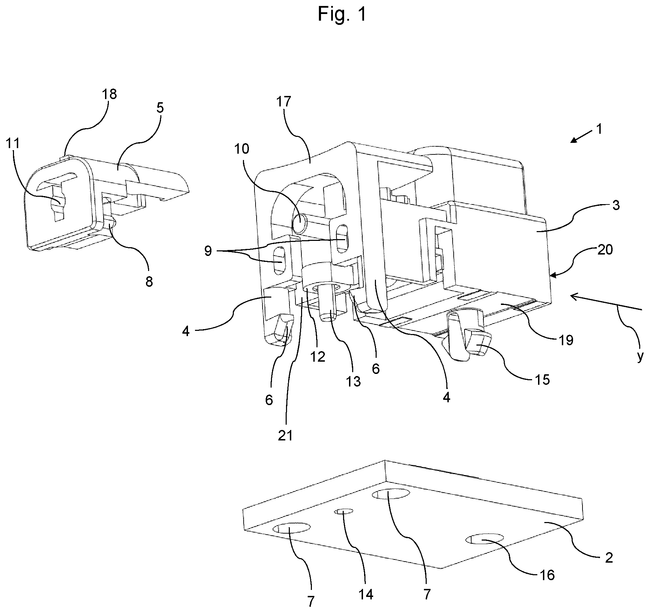

Figur 1 zeigt eine erste Ausführungsform des erfindungsgemäßen Steckverbinders 1 in einer dreidimensionalen Explosivansicht. Der Steckverbinder 1 kann lösbar an einer Leiterplatine 2 befestigt werden und dient im Wesentlichen einer Verbindung der Leiterplatine 2 mit einem nicht gezeigten Gegensteckverbinder. Der Steckverbinder 1 besitzt ein Steckverbindergehäuse 3 und eine Sicherungseinheit 5. Das Steckverbindergehäuse 3 besitzt zwei Befestigungsarme 4, die jeweils ein erstes Befestigungselement 6 aufweisen. Die Befestigungsarme 4 sind an einer der Steckseite 20 gegenüberliegenden Rückseite 21 des Steckverbindergehäuses 3 angeordnet. Weiterhin sind die Befestigungsarme 4 an einem Ende über einen Verbindungsabschnitt 17 miteinander verbunden. In der vorliegenden Ausführungsform sind die ersten Befestigungselemente 6 als Rasthaken ausgebildet. Die ersten Befestigungselemente 6 sind mit ersten Verbindungselementen 7 an der Leiterplatine 2 verbindbar. In der vorliegenden Ausführungsform sind die ersten Verbindungselemente 7 als Rastöffnungen ausgebildet. Die Rasthaken werden zur Verbindung mit den Rastöffnungen durch die Rastöffnungen hindurchgeführt und an den Rändern der Rastöffnungen mit der Leiterplatine 2 verrastet. Um die ersten Befestigungselemente 6 mit den ersten Verbindungselementen 7 zu verbinden, werden die Befestigungsarme 4 ausgelenkt. In der vorliegenden Ausführungsform werden die beiden Befestigungsarme 4 voneinander weg und senkrecht zu einer Steckachse y ausgelenkt. Das Steckverbindergehäuse 3 besitzt an einer Grundseite 19 ein zweites Befestigungselement 15 bestehend aus einem zweiflügeligen Rasthaken. Die Rasthaken sind hierbei derart ausgeführt, dass das Steckverbindergehäuse 3 mit seiner Grundseite 19 gegen die Leiterplatine 2 vorgespannt wird, wenn das zweite Befestigungselement 15 mit dem zweiten Verbindungselement 16 verbunden ist. Das zweite Befestigungselement 15 ist mit einem zweiten Verbindungselement 16 in der Leiterplatine 2 lösbar verbindbar. Das zweite Verbindungselement ist ebenfalls als Rastöffnung ausgeführt. Die ersten Befestigungselemente 6 an den Befestigungsarmen 4 und das zweite Befestigungselement 15 sind in Form eines gleichschenkligen Dreiecks zueinander angeordnet. Das Steckverbindergehäuse 3 besitzt an der Grundseite 19 ein Positionierungselement 13, dass in einer Positionierungsöffnung 14 in der Leiterplatine 2 anordbar ist. Das Positionierungselement ist in einer Flucht, die parallel zur Steckachse y verläuft, mit dem zweiten Befestigungselement 15 angeordnet. Das Positionierungselement 13 ist an einem Anschlagelement 12 des Steckverbindergehäuses 3 angeordnet.

Die Sicherungseinheit 5 ist zwischen einer Sperrposition und einer Freigabeposition bewegbar am Steckverbindergehäuse 3 befestigbar. Um eine störungsfreie Bewegung zwischen Freigabeposition und Sperrposition zu ermöglichen, besitzt das Steckverbindergehäuse 3 ein Führungselement 10, das teilweise in einer Führungsöffnung 11 an der Sicherungseinheit 5 angeordnet ist. Das Führungselement 10 erstreckt sich parallel zur Steckachse y von der Rückseite 21 des Steckverbindergehäuses 3 weg. Die Sicherungseinheit 5 besitzt in der vorliegenden Ausführungsform zwei Fixierungselemente 8 in Form von Fixierungsstiften, die in der Sperrposition mit Aufnahmeelementen 9 an den Befestigungsarmen 4 verbunden sind. Die Aufnahmeelemente 9 sind in der vorliegenden Ausführungsform als Aufnahmeöffnungen ausgebildet. In der Sperrposition sind die Fixierungsstifte innerhalb der Aufnahmeöffnungen angeordnet. In der Freigabeposition sind die Fixierungsstifte außerhalb der Aufnahmeöffnungen angeordnet.

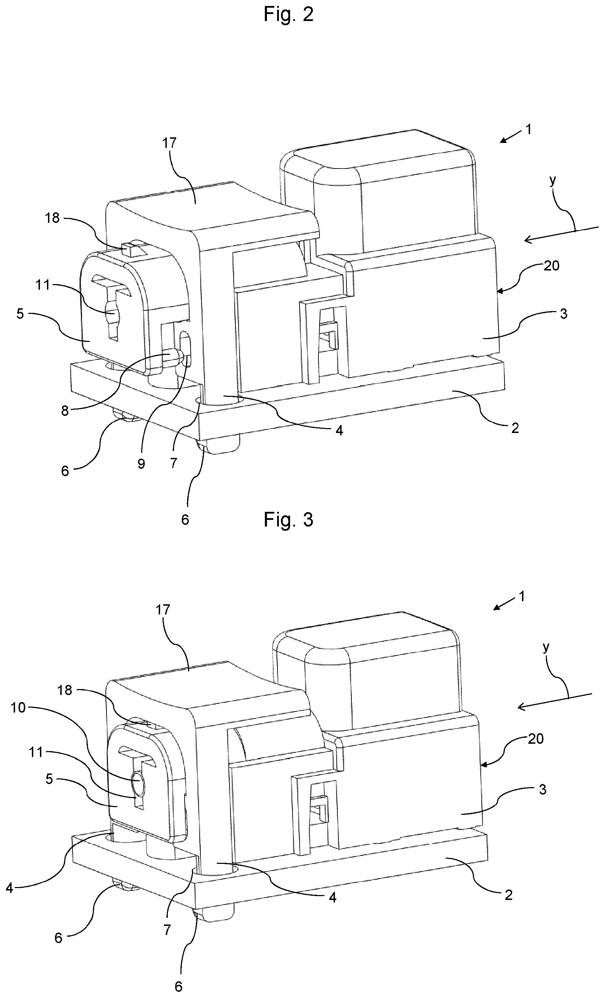

Figur 2 zeigt eine dreidimensionale Ansicht der ersten Ausführungsform des erfindungsgemäßen Steckverbinders 1, wobei die Sicherungseinheit 5 in der Freigabeposition angeordnet ist. Die Fixierelemente 8 sind fluchtend zu den Aufnahmeelementen 9 angeordnet. Die Fixierelemente 8 sind jedoch außerhalb der Aufnahmeelemente 9 angeordnet, sodass in der Freigabeposition die Befestigungsarme 4 auslenkbar sind. In der gezeigten Ansicht ist der Steckverbinder 1 über die ersten Befestigungselemente 6 und das zweite Befestigungselement lösbar mit den ersten Verbindungselementen 7 und dem zweiten Verbindungselement der Leiterplatine 2 verbunden. Durch ein erneutes Auslenken der Befestigungsarme 4 ließe sich jedoch die lösbare Verbindung der ersten Befestigungselemente 6 mit den ersten Verbindungselementen 7 auf einfache Weise lösen.

Figur 3 zeigt eine dreidimensionale Ansicht der ersten Ausführungsform des erfindungsgemäßen Steckverbinders 1, wobei die Sicherungseinheit 5 in der Sperrposition angeordnet ist. Die Fixierungselemente 8 sind mit den Aufnahmeelementen 9 verbunden. Auf diese Weise wird durch die Sicherungseinheit 5 ein Auslenken der Befestigungsarme 4 in der Sperrposition blockiert. Die Sicherungseinheit 5 besitzt ein Vorsprungselement 18, das in der vorliegenden Ausführungsform als Keil ausgebildet ist. Das Vorsprungselement 18 steht von der Sicherungseinheit 5 in Richtung Verbindungsabschnitt 17 ab. In der Sperrposition wird das Vorsprungselement 18 gegen den Verbindungsabschnitt 17 gedrückt, sodass sich der Verbindungsabschnitt 17 elastisch verformt. Die elastische Verformung und damit verbundene auftretende mechanische Spannung spannt die beiden Befestigungsarme 4 gegeneinander vor. Dies hat zur Folge, dass die Leiterplatine 2 zwischen den Befestigungsarmen 4 eingespannt wird und eine ortsfeste Fixierung des Steckverbinders 1 an der Leiterplatine 2 ermöglicht. Weiterhin wird der Steckverbinder 1 durch die Einspannung gegen die Leiterplatine 2 gedrückt.

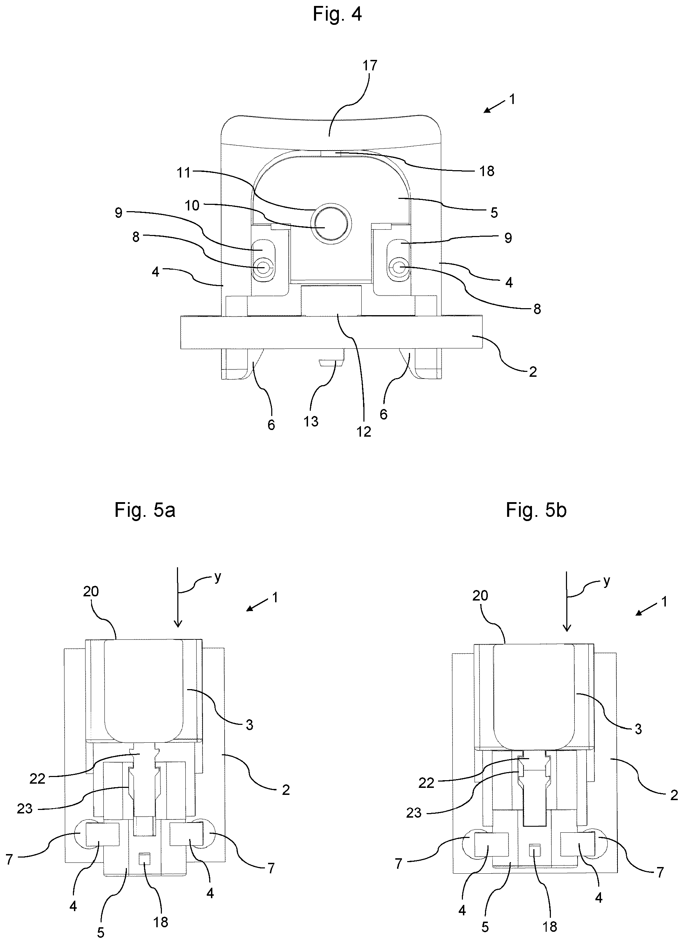

Figur 4 zeigt eine Schnittansicht der ersten Ausführungsform des erfindungsgemäßen Steckverbinders 1, wobei die Schnittebene senkrecht zur Steckachse und durch beide Befestigungsarme 4 verläuft. Die Sicherungseinheit 5 ist in der Sperrposition angeordnet, sodass die Fixierungselemente 8 mit den Aufnahmeelementen verbunden sind. Ein Auslenken der Befestigungsarme 4 wird somit blockiert. Indem die Sicherungseinheit 5 über die Führungsöffnung 11 an dem Führungselement 10 geführt ist, kann die Sicherungseinheit 5 zusätzlich stabilisiert werden, sodass auch bei größeren Kräften, die auf die Befestigungsarme 4 oder die Sicherungseinheit 5 wirken können, sichergestellt bleibt, dass sich die Fixierungselemente 8 nicht von den Aufnahmeelementen 9 lösen. Durch die Spannung, die das Vorsprungelement 19 im Verbindungsabschnitt 17 erzeugt, wird die Leiterplatine 2 nicht nur zwischen den Befestigungsarmen 4 eingespannt, sondern auch gegen das Anschlagelement 12 gedrückt.

Figuren 5a und 5b zeigen Ansichten der ersten Ausführungsform des erfindungsgemäßen Steckverbinders 1. Die Grundseite 19 ist dabei dem Betrachter abgewandt. Zur besseren Übersicht wurde der Verbindungsabschnitt entfernt. In Figur 5a befindet sich die Sicherungseinheit 5 in der Freigabeposition, während in Figur 5b die Sicherungseinheit 5 in der Sperrposition angeordnet ist. Das Steckverbindergehäuse besitzt einen Haltesteg 22, der mehrere Halteelemente aufweist. Der Haltesteg 22 ist in einer Ausnehmung 23 in der Sicherungseinheit 5 angeordnet, wobei die Freigabeposition und die Sperrposition der Sicherungseinheit 5 durch die Anordnung der Halteelemente am Haltesteg 22 definiert werden.

### BEZUGSZEICHENLISTE

- 1: Steckverbinder
- 2: Leiterplatine
- 3: Steckverbindergehäuse
- 4: Befestigungsarm
- 5: Sicherungseinheit
- 6: Erstes Befestigungselement
- 7: Erstes Verbindungselement
- 8: Fixierungselement
- 9: Aufnahmeelement
- 10: Führungselement
- 11: Führungsöffnung
- 12: Anschlagelement
- 13: Positionierungselement
- 14: Positionierungsöffnung
- 15: Zweites Befestigungselement
- 16: Zweites Verbindungselement
- 17: Verbindungsabschnitt
- 18: Vorsprungselement
- 19: Grundseite
- 20: Steckseite
- 21: Rückseite
- 22: Haltesteg
- 23: Ausnehmung

## Patentansprüche

1. Steckverbinder (1) für eine Leiterplatine (2), mit
einem Steckverbindergehäuse (3) mit zumindest einem Befestigungsarm (4)
und
einer Sicherungseinheit (5),
wobei,
der Befestigungsarm (4) zumindest ein erstes Befestigungselement (6) aufweist, das mit einem ersten Verbindungselement (7) an der Leiterplatine (2) lösbar verbindbar ist,
die Sicherungseinheit (5) zwischen einer Freigabeposition und einer Sperrposition bewegbar am Steckverbindergehäuse (3) angeordnet ist,
die Verbindung zwischen dem ersten Befestigungselement (6) und dem ersten Verbindungselement (7) durch ein Auslenken des Befestigungsarms (4) erzeugbar und/oder lösbar ist,
die Sicherungseinheit (5) die Auslenkung des Befestigungsarms (4) in der Sperrposition blockiert,
die Sicherungseinheit (5) die Auslenkung des Befestigungsarms (4) in der Freigabestellung freigibt,
**dadurch gekennzeichnet, dass**
die Sicherungseinheit (5) in einer Bewegungsrichtung, die parallel zu einer Steckachse (y) entlang derer der Steckverbinder mit einem Gegensteckverbinder verbindbar ist und parallel zu einer größten Seite der Leiterplatine (2) verläuft, zwischen der Freigabeposition und der Sperrposition bewegbar ist,
das Steckverbindergehäuse (3) ein Führungselement (10) aufweist, das sich parallel zur Steckachse (y) von dem Steckverbindergehäuse (3) wegerstreckt, zumindest teilweise innerhalb einer Führungsöffnung (11) in der Sicherungseinheit (5) angeordnet ist und die Bewegung der Sicherungseinheit zwischen der Freigabeposition und der Sperrposition führt.

2. Steckverbinder (1) gemäß dem vorhergehenden Anspruch, wobei die Sicherungseinheit (5) zumindest ein Fixierungselement (8) aufweist, das in der Sperrposition mit einem Aufnahmeelement (9) am Befestigungsarm (4) verbunden ist.

3. Steckverbinder (1) gemäß einem der vorhergehenden Ansprüche, wobei das Steckverbindergehäuse (3) zumindest ein Positionierungselement (13) aufweist, das in eine Positionierungsöffnung (14) in der Leiterplatine (2) einbringbar ist.

4. Steckverbinder (1) gemäß einem der vorhergehenden Ansprüche, wobei das Steckverbindergehäuse (3) zumindest ein Anschlagelement (12) aufweist und die Leiterplatine (2) zwischen dem ersten Befestigungselement (6) und dem Anschlagelement (12) einspannbar ist.

5. Steckverbinder (1) gemäß einem der vorhergehenden Ansprüche, wobei das Steckverbindergehäuse (3) ein zweites Befestigungselement (15) aufweist, das mit einem zweiten Verbindungselement (16) an der Leiterplatine (2) verbindbar ist.

6. Steckverbinder (1) gemäß einem der vorhergehenden Ansprüche, wobei das Steckverbindergehäuse (3) zwei Befestigungsarme (4) mit jeweils einem ersten Befestigungselement (6) aufweist, die jeweils mit einem ersten Verbindungselement (7) der Leiterplatine (2) verbindbar sind, wobei die Befestigungsarme (4) zur Erzeugung und/oder Lösung der Verbindung in zueinander entgegengesetzte Richtungen auslenkbar sind.

7. Steckverbinder (1) gemäß dem vorhergehenden Anspruch, wobei die Leiterplatine (2) zwischen den Befestigungsarmen (4) einspannbar ist.

8. Steckverbinder (1) gemäß Anspruch 6 oder 7, wobei die Befestigungsarme (4) mithilfe eines Verbindungsabschnitts (17) miteinander verbunden sind.

9. Steckverbinder (1) gemäß dem vorhergehenden Anspruch, wobei die Sicherungseinheit (5) ein Vorsprungselement (18) aufweist, das in der Sperrposition eine Druckkraft auf den Verbindungsabschnitt (17) auswirkt, die die Befestigungsarme (4) gegeneinander vorspannt.

## Claims

1. Plug-in connector (1) for a printed circuit board (2), comprising
a plug-in connector housing (3) with at least one fastening arm (4) and
a securing unit (5),
wherein
the fastening arm (4) has at least one first fastening element (6), which can be releasably connected to a first connecting element (7) on the printed circuit board (2),
the securing unit (5) is arranged on the plug-in connector housing (3) movably between a release position and a locking position,
the connection between the first fastening element (6) and the first connecting element (7) can be created and/or released by deflecting the fastening arm (4),
the securing unit (5) blocks the deflection of the fastening arm (4) in the locking position,
the securing unit (5) enables the deflection of the fastening arm (4) in the release position, **characterized in that**
the securing unit (5) can be moved between the release position and the locking position in a movement direction which runs parallel to a plug-in axis (y) along which the plug-in connector can be connected to a mating plug-in connector and parallel to a largest side of the printed circuit board (2),
the plug-in connector housing (3) has a guide element (10) which extends away from the plug-in connector housing (3) parallel to the plug-in axis (y), is arranged at least partially within a guide opening (11) in the securing unit (5) and guides the movement of the securing unit between the release position and the locking position.

2. Plug-in connector (1) according to the preceding claim, wherein the securing unit (5) has at least one fixing element (8), which is connected to a receiving element (9) on the fastening arm (4) in the locking position.

3. Plug-in connector (1) according to any of the preceding claims, wherein the plug-in connector housing (3) has at least one positioning element (13), which can be inserted into a positioning opening (14) in the printed circuit board (2).

4. Plug-in connector (1) according to any of the preceding claims, wherein the plug-in connector housing (3) has at least one stop element (12) and the printed circuit board (2) can be clamped between the first fastening element (6) and the stop element (12).

5. Plug-in connector (1) according to any of the preceding claims, wherein the plug-in connector housing (3) has a second fastening element (15), which can be connected to a second connecting element (16) on the printed circuit board (2).

6. Plug-in connector (1) according to any of the preceding claims, wherein the plug-in connector housing (3) has two fastening arms (4) each with a first fastening element (6), which first fastening elements can each be connected to a first connecting element (7) of the printed circuit board (2), wherein the fastening arms (4), for producing and/or releasing the connection, can be deflected in opposite directions.

7. Plug-in connector (1) according to the preceding claim, wherein the printed circuit board (2) can be clamped between the fastening arms (4).

8. Plug-in connector (1) according to Claim 6 or 7, wherein the fastening arms (4) are connected to each other by means of a connecting section (17).

9. Plug-in connector (1) according to the preceding claim, wherein the securing unit (5) has a projection element (18), which exerts a pressing force on the connecting section (17) in the locking position, the pressing force preloading the fastening arms (4) relative to each other.

## Revendications

1. Connecteur enfichable (1) pour une carte à circuit imprimé (2), comprenant
un boîtier de connecteur enfichable (3) comprenant au moins un bras de fixation (4) et
une unité de sécurité (5),
le bras de fixation (4) possédant au moins un premier élément de fixation (6) qui peut être relié de manière amovible à la carte à circuit imprimé (2) par un premier élément de liaison (7),
l'unité de sécurité (5) étant disposée de manière mobile sur le boîtier de connecteur enfichable (3) entre une position de libération et une position de blocage,
la liaison entre le premier élément de fixation (6) et le premier élément de liaison (7) pouvant être établie et/ou détachée par une déviation du bras de fixation (4), l'unité de sécurité (5) bloquant la déviation du bras de fixation (4) dans la position de blocage,
l'unité de sécurité (5) libérant la déviation du bras de fixation (4) dans la position de libération, **caractérisé en ce que**
l'unité de sécurité (5) est mobile entre la position de libération et la position de blocage dans une direction de déplacement, qui est parallèle à un axe d'enfichage (y) le long duquel le connecteur enfichable peut être relié à un connecteur enfichable homologue et qui est parallèle à un côté le plus long de la carte à circuit imprimé (2),
le boîtier de connecteur enfichable (3) possède un élément de guidage (10) qui s'étend parallèlement à l'axe d'enfichage (y) depuis le boîtier de connecteur enfichable (3), est disposé au moins en partie à l'intérieur d'une ouverture de guidage (11) dans l'unité de sécurité (5) et guide le mouvement de l'unité de sécurité entre la position de libération et la position de blocage.

2. Connecteur enfichable (1) selon la revendication précédente, l'unité de sécurité (5) possédant au moins un élément de calage (8) qui, en position de blocage, est relié à un élément de réception (9) sur le bras de fixation (4).

3. Connecteur enfichable (1) selon l'une des revendications précédentes, le boîtier de connecteur enfichable (3) possédant au moins un élément de positionnement (13) qui peut être introduit dans une ouverture de positionnement (14) dans la carte à circuit imprimé (2).

4. Connecteur enfichable (1) selon l'une des revendications précédentes, le boîtier de connecteur enfichable (3) possédant au moins un élément de butée (12) et la carte à circuit imprimé (2) pouvant être serrée entre le premier élément de fixation (6) et l'élément de butée (12).

5. Connecteur enfichable (1) selon l'une des revendications précédentes, le boîtier de connecteur enfichable (3) possédant un deuxième élément de fixation (15) qui peut être relié à un deuxième élément de liaison (16) sur la carte à circuit imprimé (2).

6. Connecteur enfichable (1) selon l'une des revendications précédentes, le boîtier de connecteur enfichable (3) possédant deux bras de fixation (4) qui possèdent chacun un premier élément de fixation (6), qui peuvent respectivement être reliés à un premier élément de liaison (7) de la carte à circuit imprimé (2), les bras de fixation (4) pouvant être déviés dans des directions opposées les unes aux autres pour établir et/ou détacher la liaison.

7. Connecteur enfichable (1) selon la revendication précédente, la carte à circuit imprimé (2) pouvant être serrée entre les bras de fixation (4).

8. Connecteur enfichable (1) selon la revendication 6 ou 7, les bras de fixation (4) étant reliés entre eux à l'aide d'une portion de liaison (17).

9. Connecteur enfichable (1) selon la revendication précédente, l'unité de sécurité (5) possédant un élément en saillie (18) qui, dans la position de blocage, exerce une force de pression sur la portion de liaison (17) qui précontraint les bras de fixation (4) l'un contre l'autre.
